# EUROPEAN PATENT APPLICATION

(11) **EP 4 561 082 A1**
(43) Date of publication of application: **28.05.2025**
(21) Application number: 23863367.1
(22) Date of filing: 14.08.2023
(51) Int. Cl.: H04N 23/57, H04N 23/54, H04N 23/55, H05K 1/11, H05K 1/14

(54) **CAMERA MODULE AND ELECTRONIC APPARATUS INCLUDING SAME**

(30) Priority: 08.09.2022 KR 20220114312; 22.09.2022 KR 20220119965
(71) Applicant: Samsung Electronics Co., Ltd., Suwon-si, Gyeonggi-do 16677 (KR)
(72) Inventor: HWANG, Cheol, Suwon-si Gyeonggi-do 16677 (KR)
(74) Representative: HGF
(86) International application number: PCT/KR2023/012022
(87) International publication number: WO 2024/053888

(57) **Abstract**

A camera module according to an embodiment may comprise: a lens; an image sensor which converts light incident through the lens into an electrical signal and comprises a connection pad; and a printed circuit board electrically connected to the image sensor. The printed circuit board may comprise: a plurality of layers; and a first via formed to penetrate at least some of the plurality of layers. The connection pad and the first via may be electrically connected to each other by a wire.

## Description

### TECHNICAL FIELD

The disclosure relates to a camera module and an electronic device including the same.

### BACKGROUND ART

An electronic device including a camera may provide an image-capture function. For example, the electronic device may output an image obtained from the camera to a display and may obtain a captured image from the camera by using a shutter.

### DISCLOSURE OF THE INVENTION

According to an embodiment, a camera module includes a lens, an image sensor configured to convert light incident through the lens into an electrical signal and including a connection pad, and a printed circuit board electrically connected to the image sensor. The printed circuit board may include a plurality of layers and a first via penetrating at least some of the plurality of layers. The connection pad may be electrically connected to the first via by a wire.

According to an embodiment, an electronic device includes a housing forming the exterior of the electronic device and a camera module at least partially included inside the housing. The camera module may include a lens, an image sensor configured to convert light incident through the lens into an electrical signal and including a connection pad, a connector configured to electrically connect the camera module to the electronic device, and a printed circuit board having the image sensor connected to one side thereof and the connector connected to the other side thereof. The printed circuit board may include a plurality of layers and a first via penetrating at least some of the plurality of layers. The connection pad may be electrically connected to the first via by a wire.

A separate connection pad and/or pattern may be omitted from the top layer of the printed circuit board in a camera module and an electronic device including the same according to an embodiment. Thus, noise that may be caused when a signal is relayed along a connecting path may be reduced.

The camera module and the electronic device including the same according to an embodiment may form a connecting path with relatively fewer connection pads, vias, and/or patterns.

The effects of the camera module and the electronic device including the same according to an embodiment may not be limited to said effects, and other unstated effects may be clearly understood from the following description by one skilled in the art.

### BRIEF DESCRIPTION OF THE DRAWINGS

FIG. 1 is a block diagram illustrating an electronic device in a network environment, according to various embodiment.
FIG. 2 is a block diagram illustrating a camera module according to various embodiment.
FIG. 3A is a front perspective view of an electronic device according to various embodiments.
FIG. 3B is a rear perspective view of the electronic device according to various embodiments.
FIG. 4A is a perspective view of a camera module according to an embodiment.
FIG. 4B is a schematic cross-sectional view of the camera module according to an embodiment.
FIG. 4C is a schematic plan view of a printed circuit board of the camera module according to an embodiment.
FIG. 5A is a schematic cross-sectional view of a camera module according to a comparative embodiment.
FIG. 5B is a schematic plan view of a printed circuit board of the camera module according to a comparative embodiment.

### BEST MODE FOR CARRYING OUT THE INVENTION

Hereinafter, embodiments are described in detail with reference to the accompanying drawings. When describing the embodiments with reference to the accompanying drawings, like reference numerals refer to like elements and a repeated description related thereto will be omitted.

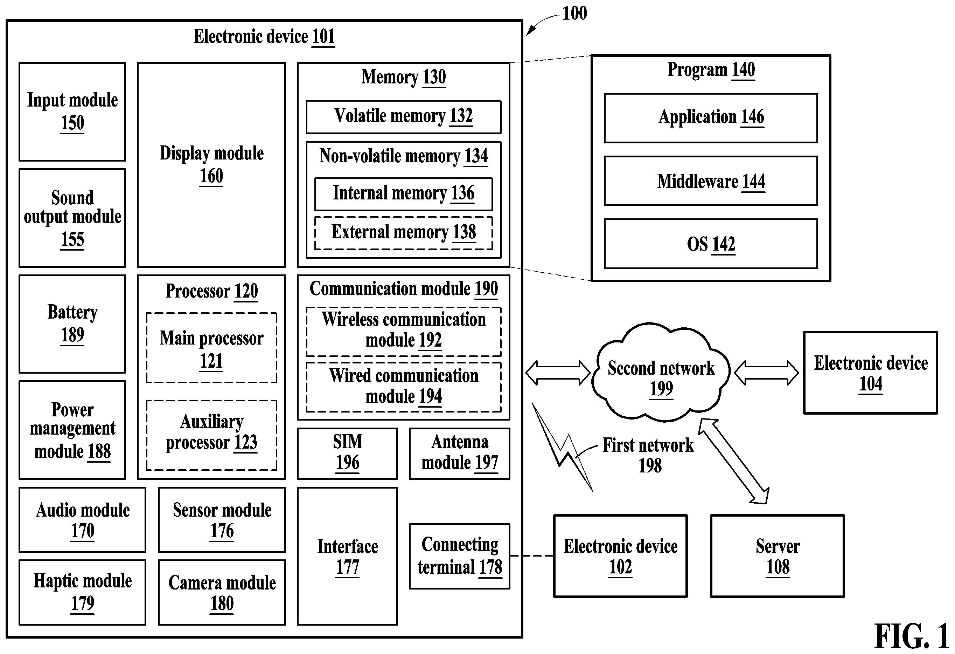

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or communicate with at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, and a sensor module 176, an interface 177, a connecting terminal 178, a haptic module 179, a camera module 180, a power management module 188, a battery 189, a communication module 190, a subscriber identification module (SIM) 196, or an antenna module 197. In some examples, at least one (e.g., the connecting terminal 178) of the above components may be omitted from the electronic device 101, or one or more other components may be added in the electronic device 101. In some examples, some (e.g., the sensor module 176, the camera module 180, or the antenna module 197) of the components may be integrated as a single component (e.g., the display module 160).

The processor 120 may execute, for example, software (e.g., a program 140) to control at least one other component (e.g., a hardware or software component) of the electronic device 101 connected to the processor 120 and may perform various data processing or computation. According to an embodiment, as at least a part of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently of, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101 instead of the main processor 121 while the main processor 121 is in an inactive (e.g., sleep) state or along with the main processor 121 while the main processor 121 is an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence (AI) model processing. An AI model may be generated by machine learning. The machine learning may be performed by, for example, the electronic device 101, in which AI is performed, or performed via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof, but examples are not limited thereto. The AI model may additionally or alternatively include a software structure other than the hardware structure.

The memory 130 may store various pieces of data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive, from outside (e.g., a user) the electronic device 101, a command or data to be used by another component (e.g., the processor 120) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing a recording. The receiver may be used to receive an incoming call. According to an embodiment, the receiver may be implemented separately from the speaker or as a part of the speaker.

The display module 160 may visually provide information to the outside (e.g., a user) of the electronic device 101. The display module 160 may include, for example, a control circuit for controlling a display, a hologram device, or a projector and control circuitry to control a corresponding one of the display, the hologram device, and the projector. According to an embodiment, the display device 160 may include a touch sensor adapted to sense a touch or a pressure sensor adapted to measure the intensity of a force incurred by the touch.

The audio module 170 may convert a sound into an electric signal or vice versa. According to an embodiment, the audio module 170 may obtain the sound via the input module 150 or may output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101 and may generate an electric signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used by the electronic device 101 to couple with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electric signal into a mechanical stimulus (e.g., a vibration or a movement) or an electrical stimulus, which may be recognized by a user via their tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell that is not rechargeable, a secondary cell that is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently from the processor 120 (e.g., an AP) and that support direct (e.g., wired) communication or wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or IR data association (IrDA)) or the second network 199 (e.g., a long-range communication network, such as a legacy cellular network, a 5G network, a next-generation communication network, the Internet, or a computer network (e.g., a LAN or a wide area network (WAN)). These various types of communication modules may be implemented as a single component (e.g., a single chip) or may be implemented as multi-components (e.g., multi-chips) separate from each other. The wireless communication module 192 may identify and authenticate the electronic device 101 in a communication network, such as the first network 198 or the second network 199, by using subscriber information (e.g., international mobile subscriber identity (IMSI)) stored in the SIM 196.

The wireless communication module 192 may support a 5G network after a 4G network, and next-generation communication technology, for example, new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, for example, a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beamforming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or the power may be transmitted or received between the communication module 190 and the external electronic device via the at least one selected antenna. According to an embodiment, another component (e.g., a radio frequency integrated circuit (RFIC)) other than the radiating element may be additionally formed as a part of the antenna module 197.

According to an embodiment, the antenna module 197 may form a mmWave antenna module. According to an embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of the same type as or a different type from the electronic device 101. According to an embodiment, all or some of operations to be executed by the electronic device 101 may be executed at one or more external electronic devices (e.g., the external devices 102 and 104, and the server 108). For example, if the electronic device 101 needs to perform a function or a service automatically, or in response to a request from a user or another device, the electronic device 101, instead of, or in addition to, executing the function or the service, may request the one or more external electronic devices to perform at least part of the function or service. The one or more external electronic devices receiving the request may perform the at least part of the function or service, or an additional function or an additional service related to the request and may transfer a result of the performance to the electronic device 101. The electronic device 101 may provide the result, with or without further processing the result, as at least part of a response to the request. To that end, cloud computing, distributed computing, mobile edge computing (MEC), or client-server computing technology may be used, for example. The electronic device 101 may provide ultra-low-latency services using, for example, distributed computing or MEC. In another embodiment, the external electronic device 104 may include an Intemet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

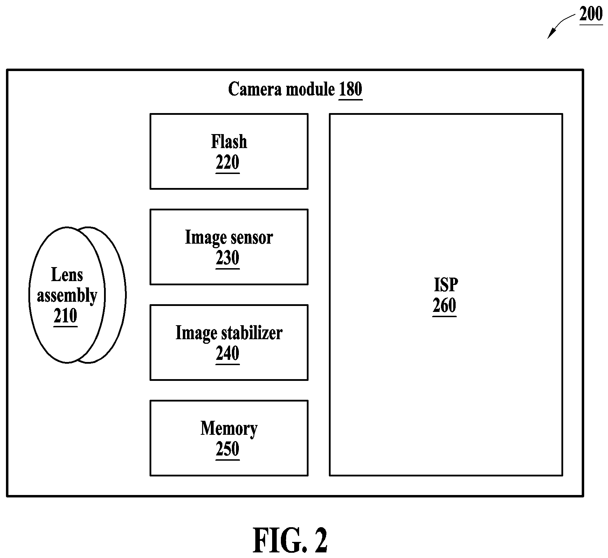

FIG. 2 is a block diagram 200 illustrating the camera module 180 according to various embodiments. Referring to FIG. 2, the camera module 180 may include a lens assembly 210, a flash 220, an image sensor 230, an image stabilizer 240, a memory 250 (e.g., a buffer memory), or an ISP 260. The lens assembly 210 may collect light emitted from an object, which is a target from which an image is to be captured. The lens assembly 210 may include one or more lenses. According to an embodiment, the camera module 180 may include a plurality of lens assemblies 210. In this case, the camera module 180 may be included in, for example, a dual camera, a 360-degree camera, or a spherical camera. Some of the lens assemblies 210 may have the same lens properties (e.g., an angle of view, a focal length, an auto focus, an f number, or an optical zoom), or at least one lens assembly may have one or more lens properties that are different from those of another lens assembly. The lens assembly 210 may include, for example, a wide-angle lens or a telephoto lens.

The flash 220 may emit light to be used to enhance light emitted or reflected from the object. According to an embodiment, the flash 220 may include one or more light emitting diodes (LEDs) (e.g., a red-green-blue (RGB) LED, a white LED, an IR LED, or an ultraviolet (UV) LED), or a xenon lamp. The image sensor 230 may obtain an image corresponding to the object by converting light emitted or reflected from the object and transmitted through the lens assembly 210 into an electrical signal. According to an embodiment, the image sensor 230 may include, for example, one image sensor selected from among image sensors having different properties, such as, for example, an RGB sensor, a black and white (BW) sensor, an IR sensor, or a UV sensor, a plurality of image sensors having the same property, or a plurality of image sensors having different properties. Each image sensor included in the image sensor 230 may be implemented using, for example, a charged coupled device (CCD) sensor or a complementary metal-oxide-semiconductor (CMOS) sensor.

The image stabilizer 240 may move at least one lens included in the lens assembly 210 or the image sensor 230 in a specific direction, or control an operation characteristic (e.g., adjust the read-out timing) of the image sensor 230, in response to a movement of the camera module 180 or the electronic device 101 including the camera module 180. This may compensate for at least some of the negative effects of the movement in an image to be captured. According to an embodiment, the image stabilizer 240 may sense such a movement of the camera module 180 or the electronic device 101 using a gyro sensor (not shown) or an acceleration sensor (not shown) inside or outside the camera module 180. According to an embodiment, the image stabilizer 240 may be implemented as, for example, an optical image stabilizer. The memory 250 may temporarily store at least a portion of the image obtained through the image sensor 230 for a subsequent image processing operation. For example, when image obtainment is delayed by a shutter or a plurality of images is obtained at a high speed, an obtained original image (e.g., a Bayer-patterned image or a high-resolution image) may be stored in the memory 250 and a copy image (e.g., a low-resolution image) corresponding to the original image may be previewed through the display module 160. Subsequently, when a specified condition (e.g., a user input or a system command) is satisfied, at least a portion of the original image stored in the memory 250 may be obtained and processed by, for example, the ISP 260. According to an embodiment, the memory 250 may be configured as at least a part of the memory 130 or as a separate memory operated independently of the memory 130.

The ISP 260 may perform one or more image processing operations on an image obtained through the image sensor 230 or an image stored in the memory 250. The image processing operations may include, for example, depth map generation, three-dimensional (3D) modeling, panorama generation, feature point extraction, image synthesis, or image compensation (e.g., noise reduction, resolution adjustment, brightness adjustment, blurring, sharpening, or softening). Additionally or alternatively, the ISP 260 may control at least one of the components (e.g., the image sensor 230) included in the camera module 180. For example, the ISP 260 may control exposure time, read-out timing, or the like. The image processed by the ISP 260 may be stored again in the memory 250 for further processing or may be provided to an external component (e.g., the memory 130, the display module 160, the electronic device 102, the electronic device 104, or the server 108) of the camera module 180. According to an embodiment, the ISP 260 may be configured as at least a part of the processor 120 or as a separate processor operated independently of the processor 120. When the ISP 260 is configured as a processor separate from the processor 120, at least one image processed by the ISP 260 may be displayed as it is without a change or be displayed through the display module 160 after additional image processing is performed by the processor 120.

According to an embodiment, the electronic device 101 may include a plurality of camera modules 180 having different properties or functions. In this case, for example, at least one of the plurality of camera modules 180 may be a wide-angle camera, and at least another one of the plurality of camera modules 180 may be a telephoto camera. Similarly, at least one of the camera modules 180 may be a front camera, and at least another one of the camera modules 180 may be a rear camera.

The electronic device according to various embodiments may be one of various types of electronic devices. The electronic device may include, for example, a portable communication device (e.g., a smartphone), a computer device, a portable multimedia device, a portable medical device, a camera, a wearable device, or a home appliance device. According to an embodiment of the disclosure, the electronic device is not limited to those described above.

It should be appreciated that an embodiment of the present disclosure and the terms used therein are not intended to limit the technological features set forth herein to particular embodiments and include various changes, equivalents, or replacements for a corresponding embodiment. In connection with the description of the drawings, like reference numerals may be used for similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "A, B, or C," each of which may include any one of the items listed together in the corresponding one of the phrases, or all possible combinations thereof. Terms such as "first", "second" or "first" or "second" may simply be used to distinguish the component from other components in question, and do not limit the components in other aspects (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., by wire), wirelessly, or via a third element.

As used in connection with an embodiment of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

An embodiment as set forth herein may be implemented as software (e.g., the program 140) including one or more instructions that are stored in a storage medium (e.g., an internal memory 136 or an external memory 138) that is readable by a machine (e.g., the electronic device 101) For example, a processor (e.g., the processor 120) of the machine (e.g., the electronic device 101) may invoke at least one of the one or more instructions stored in the storage medium and execute it. This allows the machine to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where the data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., a compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as a memory of the manufacturer's server, a server of the application store, or a relay server.

According to an embodiment, each component (e.g., a module or a program) of the above-described components may include a single entity or multiple entities, and some of the multiple entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to an embodiment, the integrated component may still perform one or more functions of each of the plurality of components in the same or similar manner as they are performed by a corresponding one among the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

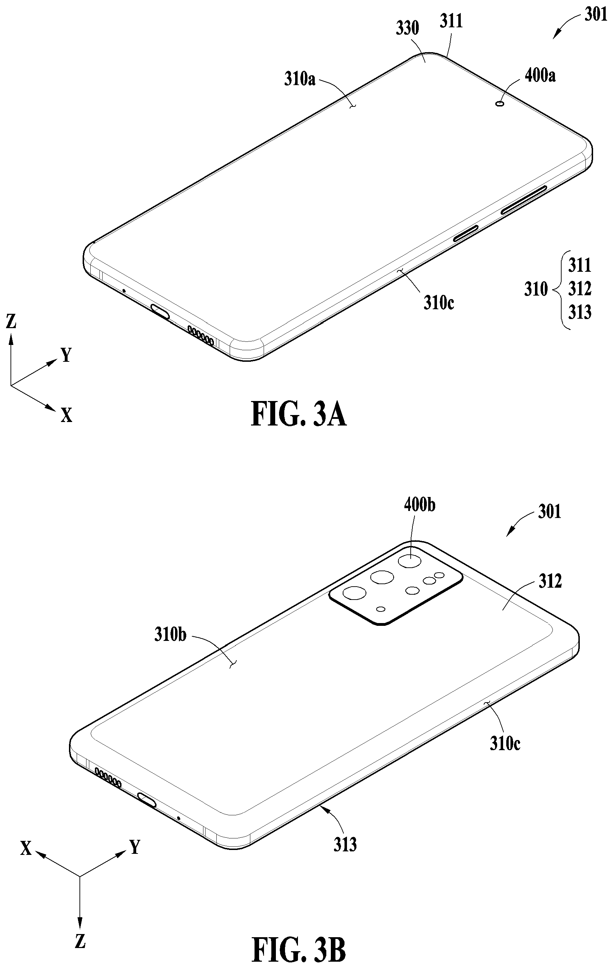

FIG. 3A is a front perspective view of an electronic device according to various embodiments, and FIG. 3B is a rear perspective view of the electronic device according to various embodiments.

Referring to FIGS. 3A and 3B, an electronic device 301 (e.g., the electronic device 101 of FIG. 1) according to an embodiment may include a housing 310, a display 330 (e.g., the display module 160 of FIG. 1), and camera modules 400a and 400b (e.g., the camera module 180 of FIG. 1).

The housing 310 may form the exterior of the electronic device 301. The housing 310 may form a front surface 310a (e.g., a first surface), a rear surface 310b (e.g., a second surface), and a side surface 310c (e.g., a third surface) surrounding an inner space between the front surface 310a and the rear surface 310b. For example, the housing 310 may include a first plate 311 (e.g., a front plate), a second plate 312 (e.g., a rear plate), and a side member 313 (e.g., a side bezel structure).

In an embodiment, the front surface 310a may be formed by the first plate 311 of which at least a portion is substantially transparent. For example, the first plate 311 may include a polymer plate or a glass plate including at least one coating layer. In an embodiment, the rear surface 310b may be formed of the second plate 312 that is substantially opaque. For example, the second plate 312 may be formed of coated or tinted glass, ceramic, polymer, metal (e.g., aluminum, stainless steel, or magnesium), or a combination thereof. The side surface 310c may be coupled to the first plate 311 and the second plate 312 and may be formed by the side member 313 including metal and/or polymer. In an embodiment, the second plate 312 and the side member 313 may be integrally and seamlessly formed. In an embodiment, the second plate 312 and the side member 313 may be formed of substantially the same material (e.g., aluminum).

In an embodiment, the side member 313 may surround at least a portion of the inner space between the front surface 310a and the rear surface 310b. A support member (not shown) may be disposed in the inner space of the housing 310. For example, the support member may be connected to the side member 313 or may be formed integrally with the side member 313. The support member may form an arrangement space of components of the electronic device 301. For example, the display 330 and/or the camera modules 400a and 400b may be fixedly connected to the support member.

In an embodiment, the electronic device 301 may include the display 330 (e.g., the display module 160 of FIG. 1). In an embodiment, the display 330 may be disposed on the front surface 310a. In an embodiment, the display 330 may be visible through at least a portion of the front plate 311. In an embodiment, the display 330 may have a shape that is substantially the same as the shape of an outer edge of the first plate 311. In an embodiment, an edge of the display 330 may substantially coincide with the outer edge of the first plate 311.

In an embodiment, at least a portion of the camera modules 400a and 400b may be disposed inside the housing 310. In an embodiment, the camera modules 400a and 400b may be disposed to be visible through the front surface 310a and/or the rear surface 310b of the housing 310. In an embodiment, the camera modules 400a and 400b may be disposed on a back surface (e.g., a surface facing a -z and/or +z direction) of at least one of the front surface 310a and/or the rear surface 310b of the housing 310 so as to face at least one of the front surface 310a and/or the rear surface 310b. For example, the camera modules 400a and 400b may not be visually exposed and may include a hidden under display camera (UDC). The camera modules 400a and 400b shown in FIGS. 3A and 3B are merely an example and positions, sizes, and/or number of the camera modules 400a and 400b are not limited thereto.

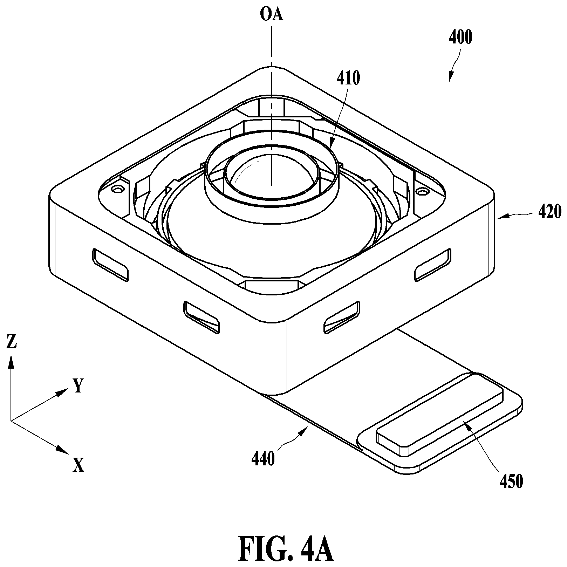

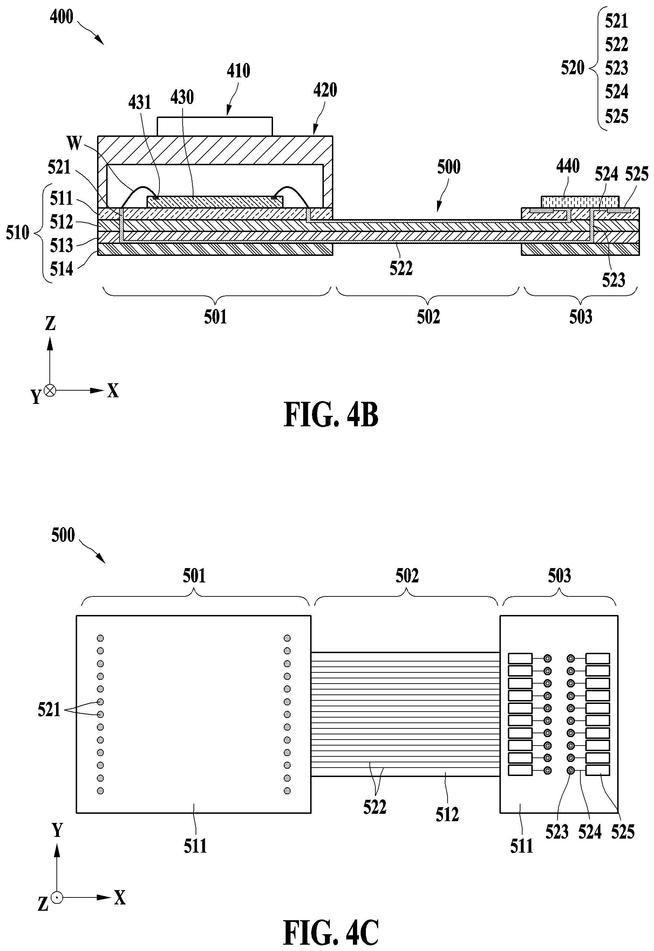

FIG. 4A is a perspective view of a camera module according to an embodiment. FIG. 4B is a schematic cross-sectional view of the camera module according to an embodiment. FIG. 4C is a schematic plan view of a printed circuit board of the camera module according to an embodiment.

Referring to FIGS. 4A to 4C, a camera module 400 (e.g., the camera module 180 of FIG. 1) according to an embodiment may include a lens 410 (e.g., the lens assembly 210 of FIG. 2), a housing 420, an image sensor 430 (e.g., the image sensor 230 of FIG. 2), a connector 440, and a PCB 500.

In an embodiment, the lens 410 may have an optical axis (OA). At least one lens 410 may be provided. For example, a plurality of lenses 410 may be aligned in the OA.

In an embodiment, the housing 420 may form the exterior of the camera module 400. For example, the housing 420 may form a space where components of the camera module 400 are arranged. For example, the housing 420 may at least partially surround the lens 410 and/or the image sensor 430.

In an embodiment, the image sensor 430 may convert light incident through the lens 410 into an electrical signal. The image sensor 430 may be on the PCB 500. The image sensor 430 may be substantially aligned with the OA of the lens 410. The image sensor 430 may include a connection pad 431. The connection pad 431 may be a component for electrically connecting the image sensor 430 to the PCB 500. For example, the connection pad 431 may be formed of an electrically conductive material. For example, at least one connection pad 431 may be provided.

In an embodiment, the connector 440 may be a component for electrically connecting the camera module 400 to an electronic device (e.g., the electronic device 301 of FIGS. 3A and 3B). For example, the connector 440 may electrically connect the PCB 500 of the camera module 400 to a main PCB of the electronic device 301. For example, the connector 440 may be on a side (e.g., the side of a +x direction) of the PCB 500. However, this is an example, and the position of the connector 440 is not limited thereto.

In an embodiment, various circuit elements for driving the camera module 400 may be arranged on the PCB 500. For example, the PCB 500 may be electrically connected to the image sensor 430 and/or the connector 440. For example, the image sensor 430 may be on a side (e.g., the side of a -x direction) of the PCB 500 and the connector 440 may be on the other side (e.g., the side of the +x direction) of the PCB 500. However, this is an example, and how the components are arranged on the PCB 500 is not limited thereto.

In an embodiment, the PCB 500 may include a plurality of layers 510 and a connecting path 520.

In an embodiment, the PCB 500 may be formed by stacking the plurality of layers 510. For example, the plurality of layers 510 may include a first layer 511, a second layer 512, a third layer 513, and a fourth layer 514. For example, the first layer 511 may be at the top of the PCB 500 and the fourth layer 514 may be at the bottom of the PCB 500. However, this is an example, and the number and/or position of the plurality of layers 510 are not limited thereto. For example, the plurality of layers 510 may include three or six layers.

In an embodiment, the PCB 500 may be formed to have a longitudinal direction (e.g., an x direction). At least a portion of the PCB 500 may be flexible. For example, the PCB 500 may include a first section 501, a second section 502, and a third section 503. For example, the image sensor 430 may be in the first section 501. For example, the connector 440 may be in the third section 503. The second section 502 may connect the first section 501 to the third section 503. For example, the second section 502 may be relatively flexible. For example, the first section 501 and/or the third section 503 may be relatively rigid. For example, the number of layers 510 in the second section 502 may be less than the number of layers in the first section 501 and/or the third section 503. For example, the first layer 511, the second layer 512, the third layer 513, and the fourth layer 514 may be stacked in the first section 501. For example, the first layer 511, the second layer 512, the third layer 513, and the fourth layer 514 may be stacked in the third section 503. For example, the second layer 512 and the third layer 513 may be stacked in the second section 502. However, this is an example, and the position of the first section 501, the second section 502, and/or the third section 503, solidity, and/or the number of layers 510 are not limited thereto.

In an embodiment, the PCB 500 may include the connecting path 520 for electrically connecting the image sensor 430 to the connector 440. The image sensor 430 and the connector 440 may be electrically connected through the connecting path 520. For example, the connecting path 520 may be a path through which a signal is transmitted and/or a path through which power is transmitted. At least one connecting path 520 may be formed. However, the connecting path 520 illustrated in the drawing is an example, and the number, position, and/or shape of the connecting path 520 are not limited thereto.

In an embodiment, the connecting path 520 may include a first via 521, a first pattern 522, a second via 523, a second pattern 524, and a bonding pad 525.

In an embodiment, the first via 521 may be formed in the first section 501. The first via 521 may be formed to penetrate at least some of the plurality of layers 510. The first via 521 may be formed by penetrating from the top of the PCB 500 in a downward direction (e.g., the -z direction). For example, the first via 521 may be formed to penetrate the PCB 500 in a downward direction (e.g., the -z direction) from a layer (e.g., the first layer 511) at the top of the plurality of layers 510. The first via 521 may be filled with an electrically conductive material. The first via 521 may be formed as a via fill. The electrically conductive material filled in the first via 521 may be exposed to the top of the PCB 500. At least one first via 521 may be formed. However, the first via 521 illustrated in the drawing is an example, and the number, position, and/or shape of the first via 521 are not limited thereto.

In an embodiment, the first pattern 522 may be formed on at least one of the plurality of layers 510. The first pattern 522 may be formed in a horizontal direction (e.g., an x/y direction) on the surface of any one of the plurality of layers 510. The first pattern 522 may electrically connect the first via 521 formed in the first section 501 to the second via 523 formed in the third section 503. A side (e.g., the side of the -x direction) of the first pattern 522 may be electrically connected to the first via 521. The first pattern 522 may extend from the first section 501 to the third section 503 via the second section 502. The other side (e.g., the side of the +x direction) of the first pattern 522 may be electrically connected to the second via 523. The first pattern 522 may be formed in a layer (e.g., the second layer 512 and/or the third layer 513) that is relatively in an inner side among the plurality of layers 510. The first pattern 522 may be formed in a layer (e.g., the second layer 512 and/or the third layer 513) forming the second section 502. For example, the first pattern 522 may be formed on the bottom surface (e.g., a surface in the -z direction) of the third layer 513. For example, the first pattern 522 may be formed on the top surface (e.g., a surface in the +z direction) of the second layer 512. At least one first pattern 522 may be formed. However, the first pattern 522 illustrated in the drawing is an example, and the number, position, and/or shape of the first pattern 522 are not limited thereto.

In an embodiment, the second via 523 may be formed in the third section 503. The second via 523 may be formed to penetrate at least some of the plurality of layers 510. The second via 523 may be formed by penetrating from the top of the PCB 500 in a downward direction (e.g., the -z direction). For example, the second via 523 may be formed to penetrate the PCB 500 in a downward direction (e.g., the -z direction) from a layer (e.g., the first layer 511) at the top of the plurality of layers 510. At least one second via 523 may be formed. However, the second via 523 illustrated in the drawing is an example, and the number, position, and/or shape of the second via 523 are not limited thereto.

In an embodiment, the second pattern 524 may be formed in the third section 503. The second pattern 524 may be formed in a layer (e.g., the first layer 511) that is at the top of the plurality of layers 510. For example, the second pattern 524 may be formed on the top surface (e.g., a surface in the +z direction) of the first layer 511. The second pattern 524 may be formed in the horizontal direction (e.g., the x/y direction). The second pattern 524 may electrically connect the second via 523 to the bonding pad 525. A side (e.g., the side of the -z direction) of the second pattern 524 may be electrically connected to the second via 523. The other side (e.g., the side of the -z direction) of the second pattern 524 may be electrically connected to the bonding pad 525. At least one second pattern 524 may be formed. However, the second pattern 524 illustrated in the drawing is an example, and the number, position, and/or shape of the second pattern 524 are not limited thereto.

In an embodiment, the bonding pad 525 may be in the third section 503. The bonding pad 525 may be in a layer (e.g., the first layer 511) that is at the top of the plurality of layers 510. For example, the bonding pad 525 may be on the top surface (e.g., a surface in the +z direction) of the first layer 511. The bonding pad 525 may be formed in the horizontal direction (e.g., the x/y direction). The second pad 525 may be formed of an electrically conductive material. The bonding pad 525 may be a component for electrically connecting the connector 440 to the PCB 500. At least one bonding pad 525 may be provided. However, the bonding pad 525 illustrated in the drawing is an example, and the number, position, and/or shape of the bonding pad 525 are not limited thereto.

In an embodiment, the image sensor 430 may be electrically connected to the PCB 500 through a wire W. For example, the connecting pad 431 of the image sensor 430 may be electrically connected to the first via 521 of the PCB 500 through the wire W. For example, a side and the other side of the wire W may be directly connected to the connecting pad 431 of the image sensor 430 and the first via 521 of the PCB 500 through bonding, respectively. For example, the side of the wire W may be directly connected to the connecting pad 431 and the other side of the wire W may be directly connected to the first via 521. For example, the other side of the wire W may be directly connected to the electrically conductive material filled in the first via 521. For example, since the electrically conductive material filled in the first via 521 is exposed to the top of the PCB 500, the other side of the wire W may be directly connected to the electrically conductive material filled in the first via 521. In this structure, a separate connecting pad and/or pattern may be omitted to electrically connect the other side of the wire W to the PCB 500.

In an embodiment, the connector 440 may be connected to the PCB 500 through soldering. For example, the connector 440 may be electrically connected to the bonding pad 525 of the PCB 500 through soldering. For example, the connector 440 may be electrically connected to the PCB 500 through a surface mount device (SMD) process. However, this is merely an example, and the method of connecting the connector 440 to the PCB 500 is not limited thereto. For example, the connector 440 may be connected to the PCB 500 in the third section 503 in the substantially same method as the method of connecting the image sensor 430 to the PCB 500 in the first section 501.

In an embodiment, in the structure described above, the image sensor 430 may be electrically connected to the connector 440 via at least the first via 521, the first pattern 522, the second via 523, the second pattern 524, and/or the bonding pad 525. However, this is an example, and it may be obviously understood by those skilled in the art that some paths may be added to or excluded from the connecting path 520.

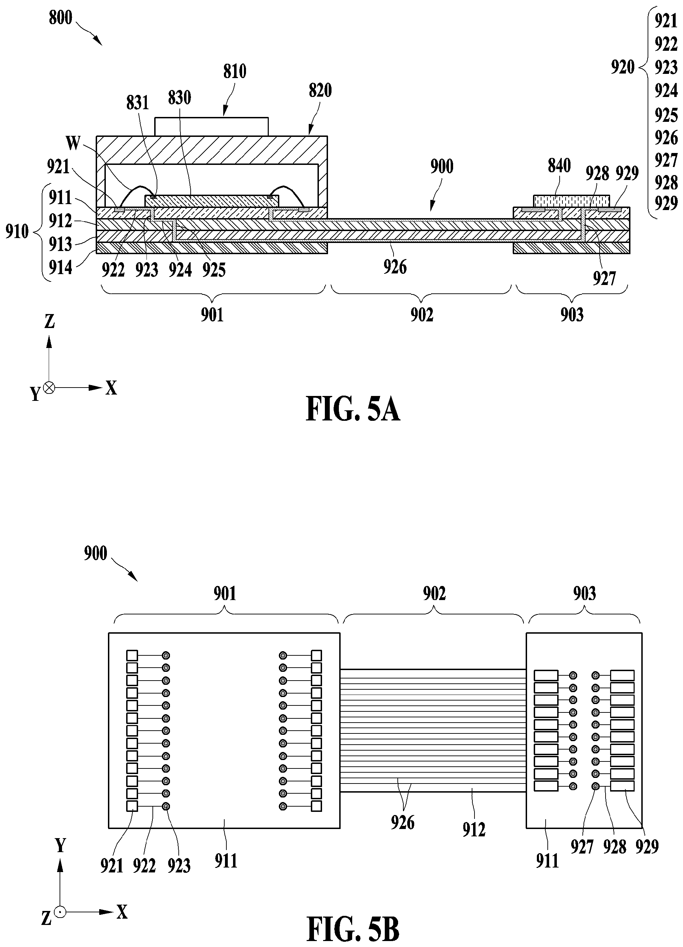

FIG. 5A is a schematic cross-sectional view of a camera module according to a comparative embodiment. FIG. 5B is a schematic plan view of a printed circuit board of the camera module according to a comparative embodiment.

Hereinafter, referring to FIGS. 5A and 5B, a camera module 800 and a PCB 900, according to a comparative embodiment, are described.

The camera module 800, according to a comparative embodiment, may include a lens 810, a housing 820, an image sensor 830, a connector 840, and the PCB 900. The PCB 900, according to a comparative embodiment, may include a plurality of layers 910 and a connecting path 920. The plurality of layers 910, according to a comparative embodiment, may include a first layer 911, a second layer 912, a third layer 913, and a fourth layer 914 that are sequentially stacked. The connecting path 920, according to a comparative embodiment, may include a connecting pad 921, a first pattern 922, a first via 923, a second pattern 924, a second via 925, a third pattern 926, a third via 927, a fourth pattern 928, and a bonding pad 929.

In a comparative embodiment, the connecting path 920 may be a path for electrically connecting the image sensor 830 to the connector 840. The connecting pad 921 may be on the top surface (e.g., a surface in the +z direction) of the first layer 911 in the first section 901. The first pattern 922 may be formed on the top surface (e.g., a surface in the +z direction) of the first layer 911 in the first section 901 and may be electrically connected to the connecting pad 921. The first via 923 may be electrically connected to the first pattern 922. The first via 923 may be formed by penetrating the PCB 900 in a downward direction (e.g., the -z direction) from the top surface (e.g., a surface in the +z direction) of the first layer 911 in the first section 901. The first via 923 may be formed by penetrating the first layer 911 from the top surface (e.g., a surface in the +z direction) of the first layer 911 to the top surface (e.g., a surface in the +z direction) of the second layer 912. The second pattern 924 may be formed on the top surface (e.g., a surface in the +z direction) of the second layer 912 in the first section 901 and may be electrically connected to the first via 923. The second via 925 may be electrically connected to the second pattern 924. The second via 925 may be formed by penetrating the PCB 900 in a downward direction (e.g., the -z direction) from the top surface (e.g., a surface in the +z direction) of the second layer 912 in the first section 901. The second via 925 may be formed by penetrating the second layer 912 and the third layer 913 from the top surface (e.g., a surface in the +z direction) of the second layer 912 to the bottom surface (e.g., a surface in the -z direction) of the third layer 913. The second terminal 850 may be formed on the bottom surface (e.g., the surface in the -z direction) of the second temple 813. The third pattern 926 may be electrically connected to the second via 925 in the first section 901 and may extend to the third section 903 via the second section 902. The third via 927 may be electrically connected to the third pattern 926. The third via 927 may be formed by penetrating the PCB 900 in an upward direction (e.g., the +z direction) from the bottom surface (e.g., a surface in the -z direction) of the third layer 913 in the third section 903. The third via 927 may be formed by penetrating the first layer 911, the second layer 912, and the third layer 913 from the bottom surface (e.g., a surface in the -z direction) of the third layer 913 to the top surface (e.g., a surface in the +z direction) of the first layer 911. The fourth pattern 928 may be formed on the top surface (e.g., a surface in the +z direction) of the first layer 911 in the third section 903 and may be electrically connected to the third via 927. The bonding pad 929 may be on the top surface (e.g., a surface in the +z direction) of the first layer 911 in the third section 903 and may be electrically connected to the fourth pattern 928.

In a comparative embodiment, the image sensor 830 may be electrically connected to the PCB 900 through the wire W. The connecting pad 831 of the image sensor 830 may be electrically connected to the connecting pad 921 of the PCB 900 through the wire W. A side of the wire W may be directly connected to the connecting pad 831 of the image sensor 830 and the other side of the wire W may be directly connected to the connecting pad 921 of the PCB 900. The connector 840 may be electrically connected to the bonding pad 929 of the PCB 900 through soldering.

Hereinafter, the camera module 400, according to an embodiment, which is described with reference to FIGS. 4A to 4C, and the camera module 800, according to a comparative embodiment, which is described with reference to FIGS. 5A and 5B, are described by comparison.

The camera module 800, according to a comparative embodiment, requires the connecting pad 921 that is at the top layer 911 of the PCB 900 to wire-bond the image sensor 830 with the PCB 900 and requires the first pattern 922 that is formed on the top layer 911 to electrically connect the connecting pad 921 to the first via 923. Meanwhile, the camera module 400, according to an embodiment, may fill an electrically conductive material in the first via 521 formed on the PCB 500 and may directly connect the wire W to the electrically conductive material filled in the first via 521. Accordingly, the camera module 400, according to an embodiment, may omit a separate connecting pad (e.g., the connecting pad 921 of FIG. 5A) and/or pattern (e.g., the first pattern 922 of FIG. 5A) to wire-bond the image sensor 430 to the PCB 500. In this structure, a separate connection pad and/or pattern may be omitted from the top layer of the PCB 500. Thus, noise that may be caused when a signal is relayed along the connecting path 520 may be reduced.

The camera module 800, according to a comparative embodiment, may require one connecting pad (e.g., the connecting pad 921), two vias (e.g., the first via 923 and the second via 925), and three patterns (e.g., the first pattern 922, the second pattern 924, and the third pattern 926) in the first section 901 when forming one connecting path 920. Meanwhile, the camera module 400, according to an embodiment, may require one via (e.g., the first via 521) and one pattern (e.g., the first pattern 522) in the first section 501 when forming one connecting path 520. In other words, the number of connecting pads, vias, and/or patterns required to form the connecting path 520 in the camera module 400, according to an embodiment, is less than that of the camera module 800, according to a comparative embodiment. Accordingly, the camera module 400, according to an embodiment, may form the connecting path 520 with relatively fewer connection pads, vias, and/or patterns. Thus, the design of the PCB 500 may be optimized. For example, the camera module 400, according to an embodiment, may reduce a space to form connecting pads, vias, and/or patterns compared to the camera module 800, according to a comparative embodiment, and moreover may reduce the whole size of the camera module 400 and/or the PCB 500.

In an embodiment, the camera module 400 may include a lens 410, an image sensor 430 configured to convert light incident through the lens 410 into an electrical signal and includes a connection pad 431, and a printed circuit board (PCB) 500 electrically connected to the image sensor 430. The printed circuit board 500 may include a plurality of layers 510 and a first via 521 penetrating at least some of the plurality of layers 510. The connection pad 431 may be electrically connected to the first via 521 by a wire W.

The first via 521 may penetrate the PCB 500 in a downward direction from a layer 511 at the top of the plurality of layers 510.

The first via 521 may be filled with an electrically conductive material.

The wire W may be directly connected to the electrically conductive material filled in the first via 521.

A connector 440 on a side of the PCB 500 may be further included.

The PCB 500 may further include a first pattern 522 formed on any one of the plurality of layers 510 to be electrically connected to the first via 521.

The printed circuit board 500 may include a first section 501, a second section 502, and a the third section 503. The image sensor 430 may be in the first section 501. The connector 440 may be in the third section 503.

The second section 502 may be flexible.

A number of layers in the second section 502 may be less than a number of layers in the first section 501 or a number of layers in the third section 503.

The first pattern 522 may extend from the first section 501 to the third section 503 via the second section 502.

The PCB 500 may further include a second via 523 formed in the third section 503.

The image sensor 430 may be electrically connected to the connector 440 by at least the first via 521, the first pattern 522, and the second via 523.

The PCB 500 may further include a bonding pad 525 on the layer 511 at the top of the plurality of layers 510 in the third section 503.

The PCB 500 may further include a second pattern 524 electrically connecting the second via 523 to the bonding pad 525.

The connector 440 may be electrically connected to the bonding pad 525 through soldering.

In an embodiment, an electronic device 301 may include a housing 310 forming an exterior of the electronic device 301 and a camera module 400 at least partially included inside the housing 310. The camera module 400 may include a lens 410, an image sensor 430 configured to convert light incident through the lens 410 into an electrical signal and includes a connection pad 431, a connector 440 configured to electrically connect the camera module 400 to the electronic device 301, and a PCB 500 having the image sensor 430 connected to one side thereof and the connector 440 connected to another side thereof. The printed circuit board 500 may include a plurality of layers 510 and a first via 521 penetrating at least some of the plurality of layers 510. The connection pad 431 may be electrically connected to the first via 521 by a wire.

The first via 521 may penetrate the PCB 500 in a downward direction from the layer 511 at the top of the plurality of layers 510.

The first via 521 may be filled with an electrically conductive material.

The wire W may be directly connected to the electrically conductive material filled in the first via 521.

The printed circuit board 500 may include a first section 501, a second section 502, and a third section 503. The image sensor 430 may be in the first section 501. The connector 440 may be in the third section 503.

## Claims

1. A camera module 400 comprising:
a lens 410;
an image sensor 430 configured to convert light incident through the lens 410 into an electrical signal and comprises a connection pad 431; and
a printed circuit board 500 electrically connected to the image sensor 430,
wherein the printed circuit board 500 comprises:
a plurality of layers 510; and
a first via 521 penetrating at least some of the plurality of layers 510, and
the connection pad 431 electrically connected to the first via 521 by a wire W.

2. The camera module 400 of claim 1, wherein
the first via 521 penetrates the printed circuit board 500 in a downward direction from a layer 511 at the top of the plurality of layers 510.

3. The camera module 400 of claim 1 or 2, wherein
the first via 521 is filled with an electrically conductive material.

4. The camera module 400 of any one of claims 1 to 3, wherein
the wire W is directly connected to the electrically conductive material filled in the first via 521.

5. The camera module 400 of any one of claims 1 to 4, further comprising:
a connector 440 on a side of the printed circuit board 500.

6. The camera module 400 of any one of claims 1 to 5, wherein
the printed circuit board 500 further comprises a first pattern 522 formed on any one of the plurality of layers 510 to be electrically connected to the first via 521.

7. The camera module 400 of any one of claims 1 to 6, wherein
the printed circuit board 500 comprises a first section 501, a second section 502, and a third section 503,
wherein the image sensor 430 is in the first section 501, and
the connector 440 is in the third section 503.

8. The camera module 400 of any one of claims 1 to 7, wherein
the second section 502 is flexible.

9. The camera module 400 of any one of claims 1 to 8, wherein
a number of layers in the second section 502 is less than a number of layers in the first section 501 or a number of layers in the third section 503.

10. The camera module 400 of any one of claims 1 to 9, wherein
the first pattern 522 extends from the first section 501 to the third section 503 via the second section 502.

11. The camera module 400 of any one of claims 1 to 10, wherein
the printed circuit board 500 further comprises a second via 523 formed in the third section 503.

12. The camera module 400 of any one of claims 1 to 11, wherein
the image sensor 430 is electrically connected to the connector 440 via at least the first via 521, the first pattern 522, and the second via 523.

13. The camera module 400 of any one of claims 1 to 12, wherein
the printed circuit board 500 further comprises a bonding pad 525on the layer 511 at the top of the plurality of layers 510 in the third section 503.

14. The camera module 400 of one of claims 1 to 13, wherein
the printed circuit board 500 further comprises a second pattern 524 configured to electrically connect the second via 523 to the bonding pad 525.

15. The camera module 400 of one of claims 1 to 14, wherein
the connector 440 is electrically connected to the bonding pad 525 through soldering.
